# EUROPEAN PATENT SPECIFICATION

(11) **EP 4 297 069 B1**
(45) Date of publication and mention of the grant of the patent: **17.09.2025**
(21) Application number: 22756022.4
(22) Date of filing: 08.02.2022
(51) Int. Cl.: H10N 30/80, H10N 30/072, H10N 30/073, H01L 21/02, H01L 21/20

(54) **COMPOSITE WAFER AND MANUFACTURING METHOD THEREFOR**
VERBUNDWAFER UND HERSTELLUNGSVERFAHREN DAFÜR
TRANCHE COMPOSITE ET SON PROCÉDÉ DE FABRICATION

(30) Priority: 19.02.2021 JP 2021025484
(43) Date of publication of application: 27.12.2023
(73) Proprietor: SHIN-ETSU CHEMICAL CO., LTD., Tokyo 1000005 (JP)
(72) Inventor: AKIYAMA, Shoji, Annaka-shi, Gunma 379-0195 (JP)
(74) Representative: Pfenning, Meinig & Partner mbB
(86) International application number: PCT/JP2022/004850
(87) International publication number: WO 2022/176701

(56) References cited:
- EP-A1- 3 136 420
- WO-A1-2018/088093
- JP-A- 2017 538 297
- JP-A- 2018 137 278
- JP-A- H01 230 255
- JP-A- H10 256 263
- JP-A- H10 256 263
- US-A1- 2016 071 959

## Description

### BACKGROUND

### 1. TECHNICAL FIELD

The present invention relates to a composite wafer and a manufacturing method therefor.

### 2. RELATED ART

As a method for bonding two wafers, there is a method in which a surface of the wafer to be bonded is treated with plasma, washed as necessary, bonded, and subjected to low-temperature heat treatment (see Patent Document 1).

Patent Document 2 discloses a multilayer composite structure and a method of preparing a multilayer composite structure. The multilayer composite structure comprises a semiconductor handle substrate having a minimum bulk region resistivity of at least about 500 ohm-cm; a silicon dioxide layer on the surface of the semiconductor handle substrate; a carbon-doped amorphous silicon layer in contact with the silicon dioxide layer; a dielectric layer in contact with the carbon-doped amorphous silicon layer; and a semiconductor device layer in contact with the dielectric layer.

Patent Document 3 discloses a method for manufacturing a bonded SOI wafer by bonding a bond wafer and a base wafer, each composed of a silicon single crystal, via an insulator film, including the steps of: depositing a polycrystalline silicon layer on the bonding surface side of the base wafer, polishing a surface of the polycrystalline silicon layer, forming the insulator film on the bonding surface of the bond wafer, bonding the polished surface of the polycrystalline silicon layer of the base wafer and the bond wafer via the insulator film, and thinning the bonded bond wafer to form an SOI layer; wherein, as the base wafer, a silicon single crystal wafer having a resistivity of 100 Ω·cm or more is used, the step for depositing the polycrystalline silicon layer further includes a stage for previously forming an oxide film on the surface of the base wafer on which the polycrystalline silicon layer is deposited, and the polycrystalline silicon layer is deposited at a temperature of 900°C or more.

Patent Document 4 discloses a manufacture process of an SOI or semiconductor element wherein a first insulating film is made on a silicon substrate, and thereon a silicon film doped with impurities of about 1x10¹⁷cm⁻³ or over lies. What is more, thereon a second insulating film, and thereon a silicon active layer are respectively made. As the impurities, boron, carbon and oxygen are suitable.

### CITATION LIST

### PATENT DOCUMENT

Patent Document 1: Japanese patent No. 6396852
Patent Document 2: US 2016/071959 A1
Patent Document 3: EP 3 136 420 A1
Patent Document 4: JP H10 256263 A

### TECHNICAL PROBLEM

However, in this plasma activation method, combining strength in a low temperature range greatly varies depending on surface material of the wafer to be bonded. In particular, when oxides and nitrides are bonded to each other, there is a problem that bonding strength at a cryogenic temperature is weak, and a joining interface is peeled off due to warpage or the like before sufficient strength is obtained.

### GENERAL DISCLOSURE

Then invention is defined by the appended set of claims. Any examples, embodiments etc. not falling within the scope of the claims are illustrative in nature.

A first aspect of the present invention is a composite wafer according to claim 1.

The silicon layer may be amorphous silicon. The silicon layer may be 2 nm or more and 250 nm or less. The silicon layer has an argon concentration of 1.5% atomic or less. The silicon layer has a surface concentration of iron, chromium, and nickel of 5.0e10 atoms/cm² or less.

Each of the first substrate and the second substrate may be any one of silicon, glass, alumina, sapphire, lithium tantalate, and lithium niobate. At least one of the first layer or the second layer may be any one of SiO₂, SiON, and SiN.

A second aspect of the present invention is a manufacturing method for a composite wafer according to claim 7.

The silicon layer may be amorphous silicon. In the forming, the silicon layer may be formed by PVD or CVD. The silicon layer may be 2 nm or more and 250 nm or less.

Each of the first substrate and the second substrate may be any one of silicon, glass, alumina, sapphire, lithium tantalate, and lithium niobate. At least one of the first layer or the second layer may be any one of SiO₂, SiON, and SiN.

One of the first substrate or the second substrate may be ion-implanted in advance. An atmosphere of activation with plasma may contain at least one of nitrogen, oxygen, a gas mixture of oxygen and nitrogen, or argon.

The summary clause does not necessarily describe all necessary features of the embodiments of the present invention. The present invention may also be a sub-combination of the features described above.

### BRIEF DESCRIPTION OF THE DRAWINGS

Fig. 1 illustrates a relationship between a substance on a surface to be bonded and joining strength.
Fig. 2 schematically illustrates a cross-sectional view of a composite wafer 10 according to the present embodiment.
Fig. 3 schematically illustrates each stage of a manufacturing method of the composite wafer 10.
Fig. 4 illustrates an optical microscope image of glass (transparent) and LT bonded with amorphous silicon of 160 nm interposed therebetween.

### DESCRIPTION OF EXEMPLARY EMBODIMENTS

Hereinafter, the present invention will be described through embodiments of the invention, but the following embodiments do not limit the invention according to claims. In addition, not all of the combinations of features described in the embodiments are essential to the solution of the invention.

The present inventors first investigated which substance has high joining strength by plasma surface activation.

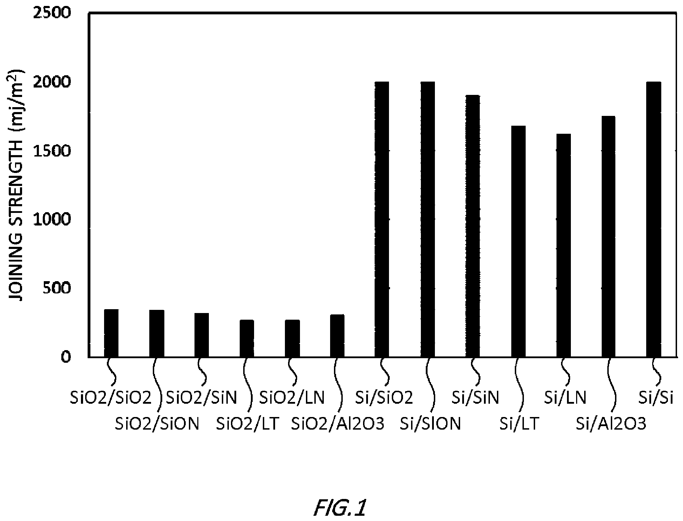

Fig. 1 illustrates a relationship between a substance on a surface to be bonded and joining strength. Activation was performed in a nitrogen atmosphere for about 30 seconds. After bonding, treatment was performed at 100°C for 24 hours. The joining strength was measured by a blade insertion method (examples of the blade insertion method include "Semiconductor Wafer Bonding-Science and Technology-" Q.-Y.Tong and U.Gosele et al., p. 25-28, John Wiley & Sons, Inc. 1999).

From this result, it can be seen that the joining strength between oxides is relatively weak. It can be seen that the joining strength increases when Si is added. However, in joining of Si/Si, the joining strength after heat treatment of 90°C was high, but the joining was peeled off when the treatment of a temperature (250°C) higher than that was performed. This is considered to be because the moisture confined in the joining interface had no escape and destroyed the joining at the time of vaporization.

With Si and other substances, the treatment at 250°C could be completed without any problem. Therefore, it can be seen that in order to obtain high joining strength at a low temperature, high joining strength can be obtained by joining Si to any one of oxides, oxynitrides, and nitrides. However, it is not always possible to use a silicon wafer as a bonded wafer.

In this regard, in the present embodiment, when one wafer surface is any one of oxides, oxynitrides, and nitrides, a thin Si film is formed on the other wafer surface. As a result, the joining of Si/oxides (or oxynitrides, nitrides) is realized.

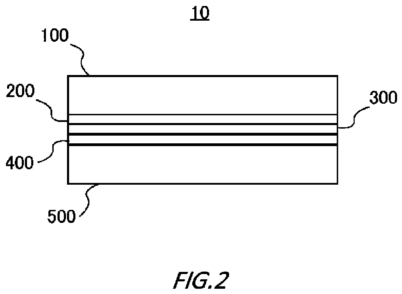

Fig. 2 schematically illustrates a cross-sectional view of a composite wafer 10 according to the present embodiment. The composite wafer 10 includes a first substrate 100, a first layer 200 disposed on one surface of the first substrate 100, a second substrate 500, a second layer 400 disposed on one surface of the second substrate 500, and a silicon layer 300 disposed between the first layer 200 and the second layer 400.

The first substrate 100 is, for example, any one of silicon, glass, alumina, sapphire, lithium tantalate, and lithium niobate. The first substrate 100 has a thickness of, for example, several hundred µm.

The first layer 200 is, for example, any one of oxides, oxynitrides, and nitrides. The first layer 200 is preferably any one of SiO₂, SiON, and SiN. The first layer 200 has a thickness of several tens nm to several µm.

The second substrate 500 is also, for example, any one of silicon, glass, alumina, sapphire, lithium tantalate, and lithium niobate. The material of the second substrate 500 may be the same as or different from the material of the first substrate 100. The second substrate 500 has a thickness of, for example, several hundred µm.

The second layer 400 is, for example, any one of oxides, oxynitrides, and nitrides. The second layer 400 is preferably any one of SiO₂, SiON, and SiN. The material of the second layer 400 may be the same as or different from the material of the first layer 200. The second layer 400 has a thickness of several tens nm to several µm.

The silicon layer 300 is what is formed on one or both of the first layer 200 and the second layer 400 and left between the first layer 200 and the second layer 400 after bonding. The silicon layer 300 is preferably amorphous silicon.

The silicon layer 300 is preferably 2 nm or more and 250 nm or less. In order to ensure high transparency in optical applications or the like and to obtain low dielectric loss in high-frequency applications, it is preferable that the silicon layer is thin. Note that, when it is not necessary to obtain high transparency and low dielectric loss, the silicon layer 300 may have a thickness of 250 nm or more. On the other hand, when the silicon layer is excessively thin, the silicon layer easily oxidizes and changes into SiO₂, and thus the silicon layer preferably has a thickness of several atomic layers or more.

A concentration of argon contained in the silicon layer 300 is 1.5% atomic or less. In addition, the surface concentration of iron, chromium, and nickel contained in the silicon layer is 5.0e10 atoms/cm² or less. These can be realized by bonding with plasma activation to be described later.

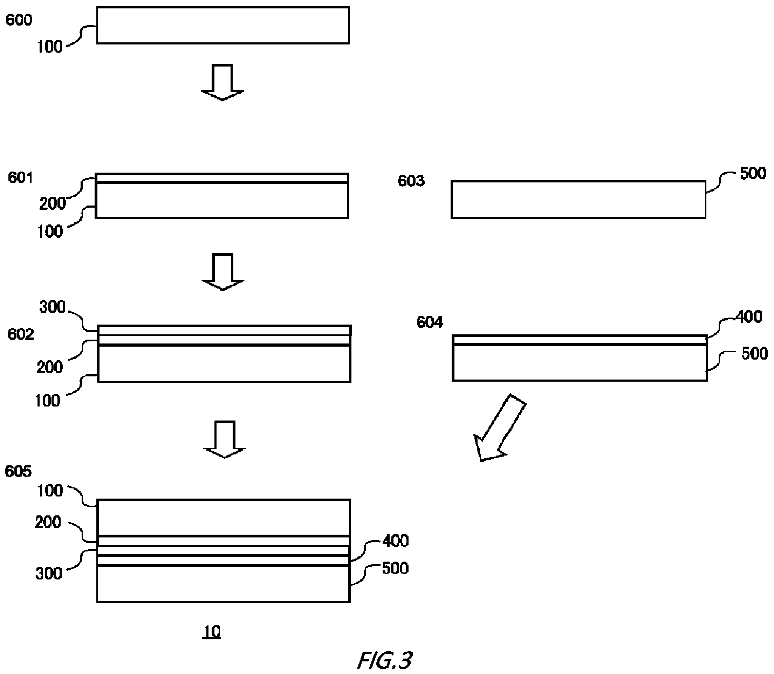

Fig. 3 schematically illustrates each stage of a manufacturing method of the composite wafer 10.

600 of Fig. 3 illustrates a stage of preparing the first substrate 100. The example of Fig. 3 shows a state of the first substrate 100 before the first layer 200 is provided. The first substrate 100 is obtained by cutting out an LT single crystal ingot formed by a pulling method into a plate shape having a thickness of several hundred µm, for example.

601 of Fig. 3 illustrates a stage of forming the first layer 200 on one surface of the first substrate 100. When the first substrate 100 is LT, the first layer 200 is, for example, SiO₂. The first layer 200 is polished after film formation to be flattened.

602 of Fig. 3 illustrates a stage of forming the silicon layer 300 on the bonding surface side of the first layer 200, that is, on the side opposite to the first substrate 100. The silicon layer 300 is amorphous silicon film formed by, for example, a physical vapor deposition (PVD) method. Instead of the PVD method, a chemical vapor deposition method (CVD) method may be used.

603 of Fig. 3 illustrates a stage of preparing the second substrate 500. The example of Fig. 3 shows a state of the second substrate 500 before the second layer 400 is provided. The second substrate 500 is obtained by cutting out a silicon single crystal ingot formed by a pulling method into a plate shape having a thickness of several hundred µm, for example.

604 of Fig. 3 illustrates a stage of forming the second layer 400 on one surface of the second substrate 500. When the second substrate 500 is silicon, the second layer 400 is, for example, SiO₂. The second layer 400 is, for example, a thermal oxide film obtained by oxidizing the second substrate 500 at around 1000°C.

605 of Fig. 3 illustrates a stage of bonding the first substrate 100 and the second substrate 500. Before bonding the first substrate 100 and the second substrate 500, at least one of the surfaces to be bonded is activated with plasma. That is, in the present embodiment, at least one of the surface of the silicon layer 300 or the surface of the second layer 400 is activated. The atmosphere of activation with plasma preferably contains at least one of nitrogen, oxygen, a gas mixture of oxygen and nitrogen, or argon.

The first substrate 100 and the second substrate 500 are bonded together on the bonding surface. In the present embodiment, the silicon layer 300 and the second layer 400 are bonded together. The bonding stage may be performed at a room temperature.

As described above, the composite wafer 10 is manufactured. In this case, high joining strength can be obtained by performing the heat treatment of a low temperature. In addition to or instead of providing the silicon layer 300 in the first layer 200, the silicon layer 300 may be provided in the second layer 400. In addition, one of the first substrate 100 or the second substrate 500 may be ion-implanted in advance.

### Example 1

A wafer obtained by forming a film of SiO₂ on an LT wafer and polishing the film was prepared. On the other side, a silicon wafer having a thermal oxide film formed was prepared. Two types of silicon wafers were prepared: a silicon wafer having an amorphous silicon film of about 10 nm formed on the thermal oxide film by the PVD method; and a silicon wafer not having the amorphous silicon film. Plasma activation was performed in a nitrogen atmosphere for 30 seconds, and after bonding, heat treatment of 100°C was performed for 24 hours. Thus, a composite wafer was obtained. There was no peeling or the like in the case where the amorphous silicon film was formed, but peeling or cracks were observed in the periphery in the case where the amorphous silicon film was not formed.

### Example 2

A wafer obtained by forming a film of SiO₂ on an LT wafer and polishing the film was prepared. On the other side, a silicon wafer having a thermal oxide film formed was prepared. Two types of LT wafers were prepared: an LT wafer having an amorphous silicon film of about 10 nm formed on the oxide film by the PVD method; and an LT wafer not having the amorphous silicon film. Plasma activation was performed in a nitrogen atmosphere for 30 seconds, and after bonding, heat treatment of 100°C was performed for 24 hours. There was no peeling or the like in the case where the amorphous silicon film was formed, but peeling or cracks were observed in the periphery in the case where the amorphous silicon film was not formed.

### Example 3

A wafer obtained by forming a film of SiON on an LT wafer and polishing the film was prepared. On the other side, a silicon wafer having a thermal oxide film formed was prepared. Two types of silicon wafers were prepared: a silicon wafer having an amorphous silicon film of about 10 nm formed on the thermal oxide film by the PVD method; and a silicon wafer not having the amorphous silicon film. Plasma activation was performed in a nitrogen atmosphere for 30 seconds, and after bonding, heat treatment of 100°C was performed for 24 hours. There was no peeling or the like in the case where the amorphous silicon film was formed, but peeling or cracks were observed in the periphery in the case where the amorphous silicon film was not formed.

### Example 4

A wafer obtained by forming a film of SiN on an LT wafer and polishing the film was prepared. On the other side, a silicon wafer having a thermal oxide film formed was prepared. Two types of silicon wafers were prepared: a silicon wafer having an amorphous silicon film of about 10 nm formed on the thermal oxide film by the PVD method; and a silicon wafer not having the amorphous silicon film. Plasma activation was performed in a nitrogen atmosphere for 30 seconds, and after bonding, heat treatment of 100°C was performed for 24 hours. There was no peeling or the like in the case where the amorphous silicon film was formed, but peeling or cracks were observed in the periphery in the case where the amorphous silicon film was not formed.

### Example 5

The LT wafer in Examples 1 to 4 was changed to LN, alumina (sapphire), and glass, and the experiment was similarly conducted, but the results were exactly the same as those in Examples 1 to 4.

### Example 6

The atmosphere for plasma activation in Examples 1 to 5 was changed to oxygen, a gas mixture of oxygen and nitrogen, and argon, and a similar experiment was conducted, but the results were the same.

### Example 7

The amorphous silicon film of about 10 nm in Examples 1 to 6 was formed by the CVD method and used to conduct a similar experiment, but the results were the same.

### Example 8

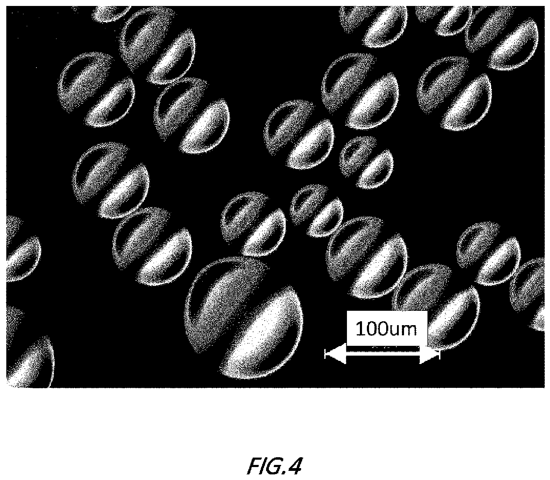

An experiment was conducted with the thickness of the amorphous silicon in Examples 1 to 7 increased. The same result was obtained up to a thickness of 250 nm, but when the thickness was 275 nm, minute peeling was observed on the entire surface of the wafer by using an optical microscope. As an example, an optical microscope image of glass (transparent) and LT bonded with amorphous silicon of 160 nm interposed therebetween is illustrated in Fig. 4. This is considered to be because impurities (such as hydrogen) taken into the amorphous silicon by the PVD method or the CVD method were volatilized, and those that could not be absorbed induced peeling. Therefore, it can be said that the thickness of the amorphous silicon is desirably 150 nm or less.

### Example 9

One of the wafers to be bonded was ion-implanted with hydrogen in advance, but the result was the same as those of Examples 1 to 8. These wafers were bonded together and then subjected to ion implantation peeling after the heat treatment, thereby obtaining a composite wafer in which thin films were laminated.

### Example 10

Only one wafer, not both wafers, was subjected to the plasma activation in Examples 1 to 9. The result was the same as those in Examples 1 to 9, regardless of which wafer was subjected to the plasma activation.

### Example 11

A wafer obtained by forming a film of SiO₂ on an LT wafer implanted with hydrogen ions in advance and polishing the film was prepared. On the other side, a silicon wafer having a thermal oxide film formed was prepared. In the silicon wafer, on the thermal oxide film was formed an amorphous silicon film of about 5 nm by the PVD method, and on the LT wafer on which the film of SiO₂ was formed was also formed an amorphous silicon film of about 5 nm. This wafer was bonded by a room-temperature joining method by using an argon beam under high vacuum. The bonded wafer was peeled off at the ion implantation interface, and heat treatment of 450°C was performed in order to recover the crystallinity disturbed by the ion implantation, but peeling occurred in a part of the wafer.

A cross section of the wafer was observed with a transmission electron microscope (TEM), the amorphous silicon was observed by energy dispersive X-ray analysis (EDX), and as a result, a high concentration of argon (1.5% or more) was observed. On the other hand, the sample obtained in Example 9 was similarly subjected to the heat treatment of 450°C, and a similar observation was conducted, but argon was not observed.

In addition, metal contamination of the silicon wafer irradiated with the argon beam used for the room-temperature joining was observed by an ICP-MS method, and iron, chromium, nickel, or the like was observed to have a high concentration of 1.0e11 atoms/cm² or more. It can be said that it is essentially difficult to escape from the metal contamination in the room-temperature joining. On the other hand, a high concentration of contamination was not observed from the silicon wafer subjected to plasma activation, and the degree of contamination for the metal was 5.0e10 atoms/cm² or less.

While the present invention has been described by way of the embodiments, the technical scope of the present invention is not limited to the above-described embodiments. It is apparent to persons skilled in the art that various alterations or improvements can be made to the above-described embodiments.

The operations, procedures, steps, stages, or the like of each process performed by a device, system, program, and method shown in the claims, embodiments, or diagrams can be performed in any order as long as the order is not indicated by "prior to," "before," or the like and as long as the output from a previous process is not used in a later process. Even if the process flow is described using phrases such as "first" or "next" in the claims, embodiments, or diagrams, it does not necessarily mean that the process must be performed in this order.

### EXPLANATION OF REFERENCES

100: first substrate;
200: first layer;
300: silicon layer;
400: second layer; and
500: second substrate.

## Claims

1. A composite wafer (10) comprising:
a first substrate (100) on which a first layer (200) of any one of oxides, oxynitrides, and nitrides is disposed;
a second substrate (500) on which a second layer (400) of any one of oxides, oxynitrides, and nitrides is disposed; and
a silicon layer (300) which is disposed between the first layer (200) and the second layer (400), **characterized in that**
the silicon layer (300) has an argon concentration of 1.5% atomic or less, and
the silicon layer (300) has a surface concentration of iron, chromium, and nickel of 5.0e10 atoms/cm² or less.

2. The composite wafer (10) according to claim 1, wherein the silicon layer (300) is amorphous silicon.

3. The composite wafer (10) according to claim 1 or 2, wherein the thickness of the silicon layer (300) is 2 nm or more and 250 nm or less.

4. The composite wafer (10) according to claim 2, wherein the thickness of the silicon layer (300) is 150 nm or less.

5. The composite wafer (10) according to any one of claims 1 to 4, wherein each of the first substrate (100) and the second substrate (500) is any one of silicon, glass, alumina, sapphire, lithium tantalate, and lithium niobate.

6. The composite wafer (10) according to claim 5, wherein at least one of the first layer (200) or the second layer (400) is any one of SiO₂, SiON, and SiN.

7. A manufacturing method for a composite wafer (10) comprising:
preparing a first substrate (100) on which a first layer (200) of any one of oxides, oxynitrides, and nitrides is disposed;
preparing a second substrate (500) on which a second layer (400) of any one of oxides, oxynitrides, and nitrides is disposed;
forming a silicon layer (300) on the first layer (200) or on the second layer (400);
activating, with plasma, a surface of at least one of the silicon layer (300) or another of the first layer (200) or the second layer (400); and
bonding the first substrate (100) and the second substrate (500),
**characterized in that**
the silicon layer (300) has an argon concentration of 1.5% atomic or less, and
the silicon layer (300) has a surface concentration of iron, chromium, and nickel of 5.0e10 atoms/cm² or less before or after the bonding.

8. The manufacturing method for the composite wafer (10) according to claim 7, wherein the silicon layer (300) is amorphous silicon.

9. The manufacturing method for the composite wafer (10) according to claim 8, wherein the silicon layer (300) is formed by PVD or CVD.

10. The manufacturing method for the composite wafer (10) according to any one of claims 7 to 9, wherein the thickness of the silicon layer (300) is 2 nm or more and 250 nm or less.

11. The manufacturing method for the composite wafer (10) according to any one of claims 7 to 10, wherein each of the first substrate (100) and the second substrate (500) is any one of silicon, glass, alumina, sapphire, lithium tantalate, and lithium niobate.

12. The manufacturing method for the composite wafer (10) according to claim 11, wherein at least one of the first layer (200) or the second layer (400) is any one of SiO₂, SiON, and SiN.

13. The manufacturing method for the composite wafer (10) according to any one of claims 7 to 12, wherein one of the first substrate (100) or the second substrate (500) is ion-implanted in advance.

14. The manufacturing method for the composite wafer (10) according to any one of claims 7 to 13, wherein an atmosphere of activation with plasma contains at least one of nitrogen, oxygen, a gas mixture of oxygen and nitrogen, or argon.

15. The manufacturing method for the composite wafer (10) according to any one of claims 7 to 13 wherein an atmosphere of activation with plasma contains argon.

## Patentansprüche

1. Verbundwafer (10), umfassend:
ein erstes Substrat (100), auf dem eine erste Schicht (200) aus einem von Oxiden, Oxynitriden und Nitriden angeordnet ist;
ein zweites Substrat (500), auf dem eine zweite Schicht (400) aus einem von Oxiden, Oxynitriden und Nitriden angeordnet ist; und
eine Siliciumschicht (300), die zwischen der ersten Schicht (200) und der zweiten Schicht (400) angeordnet ist,
**dadurch gekennzeichnet, dass**
die Siliciumschicht (300) eine Argonkonzentration von 1,5 % atomar oder weniger aufweist, und
die Siliciumschicht (300) eine Oberflächenkonzentration von Eisen, Chrom und Nickel von 5.0e10 Atomen/cm² oder weniger aufweist.

2. Verbundwafer (10) nach Anspruch 1, wobei die Siliciumschicht (300) amorphes Silicium ist.

3. Verbundwafer (10) nach Anspruch 1 oder 2, wobei die Dicke der Siliciumschicht (300) 2 nm oder mehr und 250 nm oder weniger beträgt.

4. Verbundwafer (10) nach Anspruch 2, wobei die Dicke der Siliciumschicht (300) 150 nm oder weniger beträgt.

5. Verbundwafer (10) nach einem der Ansprüche 1 bis 4, wobei jedes von dem ersten Substrat (100) und dem zweiten Substrat (500) eins von Silicium, Glas, Aluminiumoxid, Saphir, Lithiumtantalat und Lithiumniobat ist.

6. Verbundwafer (10) nach Anspruch 5, wobei mindestens eine von der ersten Schicht (200) oder der zweiten Schicht (400) eins von SiO₂, SiON und SiN ist.

7. Fertigungsverfahren für einen Verbundwafer (10), umfassend:
Vorbereiten eines ersten Substrats (100), auf dem eine erste Schicht (200) aus einem von Oxiden, Oxynitriden und Nitriden angeordnet ist;
Vorbereiten eines zweiten Substrats (500), auf dem eine zweite Schicht (400) aus einem von Oxiden, Oxynitriden und Nitriden angeordnet ist;
Bilden einer Siliciumschicht (300) auf der ersten Schicht (200) oder der zweiten Schicht (400);
Aktivieren, mit Plasma, einer Oberfläche von mindestens einer von der Siliciumschicht (300) oder einer weiteren von der ersten Schicht (200) oder der zweiten Schicht (400); und
Bonden des ersten Substrats (100) und des zweiten Substrats (500),
**dadurch gekennzeichnet, dass**
die Siliciumschicht (300) eine Argonkonzentration von 1,5 % atomar oder weniger aufweist, und
die Siliciumschicht (300) vor oder nach dem Bonden eine Oberflächenkonzentration von Eisen, Chrom und Nickel von 5.0e10 Atomen/cm² oder weniger aufweist.

8. Fertigungsverfahren für den Verbundwafer (10) nach Anspruch 7, wobei die Siliciumschicht (300) amorphes Silicium ist.

9. Fertigungsverfahren für den Verbundwafer (10) nach Anspruch 8, wobei die Siliciumschicht (300) durch PVD oder CVD ausgebildet ist.

10. Fertigungsverfahren für den Verbundwafer (10) nach einem der Ansprüche 7 bis 9,
wobei die Dicke der Siliciumschicht (300) 2 nm oder mehr und 250 nm oder weniger beträgt.

11. Fertigungsverfahren für den Verbundwafer (10) nach einem der Ansprüche 7 bis 10,
wobei jedes von dem ersten Substrat (100) und dem zweiten Substrat (500) eins von Silicium, Glas, Aluminiumoxid, Saphir, Lithiumtantalat und Lithiumniobat ist.

12. Fertigungsverfahren für den Verbundwafer (10) nach Anspruch 11, wobei mindestens eine von der ersten Schicht (200) oder der zweiten Schicht (400) eins von SiO₂, SiON und SiN ist.

13. Fertigungsverfahren für den Verbundwafer (10) nach einem der Ansprüche 7 bis 12,
wobei eins von dem ersten Substrat (100) oder dem zweiten Substrat (500) vorab mit Ionen implantiert wird.

14. Fertigungsverfahren für den Verbundwafer (10) nach einem der Ansprüche 7 bis 13,
wobei eine Atmosphäre zur Aktivierung mit Plasma mindestens eins von Stickstoff, Sauerstoff, einer Gasmischung aus Sauerstoff und Stickstoff oder Argon enthält.

15. Fertigungsverfahren für den Verbundwafer (10) nach einem der Ansprüche 7 bis 13,
wobei eine Atmosphäre zur Aktivierung mit Plasma Argon enthält.

## Revendications

1. Tranche composite (10) comprenant :
un premier substrat (100) sur lequel une première couche (200) soit en oxydes, soit en oxynitrures, soit en nitrures est disposée ;
un second substrat (500) sur lequel une seconde couche (400) soit en oxydes, soit en oxynitrures, soit en nitrures est disposée ; et
une couche en silicium (300) qui est disposée entre la première couche (200) et la seconde couche (400),
**caractérisée en ce que** :
la couche en silicium (300) présente une concentration en argon de 1,5 % en pourcentage atomique ou moins, et
la couche en silicium (300) présente une concentration en surface de fer, de chrome et de nickel de 5,0 E10 atomes/cm² ou moins.

2. Tranche composite (10) selon la revendication 1, dans laquelle la couche en silicium (300) est en silicium amorphe.

3. Tranche composite (10) selon la revendication 1 ou 2, dans laquelle l'épaisseur de la couche en silicium (300) est comprise entre 2 nm et 250 nm, bornes comprises.

4. Tranche composite (10) selon la revendication 2, dans laquelle l'épaisseur de la couche en silicium (300) est de 150 nm ou moins.

5. Tranche composite (10) selon l'une quelconque des revendications 1 à 4, dans laquelle chaque substrat parmi le premier substrat (100) et le second substrat (500) est soit en silicium, soit en verre, soit en alumine, soit en saphir, soit en tantalate de lithium, soit en niobate de lithium.

6. Tranche composite (10) selon la revendication 5, dans laquelle au moins une couche parmi la première couche (200) et la seconde couche (400) est soit en SiO₂, soit en SiON, soit en SiN.

7. Procédé de fabrication pour une tranche composite (10) comprenant :
la préparation d'un premier substrat (100) sur lequel une première couche (200) soit en oxydes, soit en oxynitrures, soit en nitrures est disposée ;
la préparation d'un second substrat (500) sur lequel une seconde couche (400) soit en oxydes, soit en oxynitrures, soit en nitrures est disposée ;
la formation d'une couche en silicium (300) sur la première couche (200) ou sur la seconde couche (400) ;
l'activation, à l'aide de plasma, d'une surface d'au moins une couche parmi la couche en silicium (300) et une autre couche parmi la première couche (200) et la seconde couche (400) ; et
la liaison du premier substrat (100) et du second substrat (500),
**caractérisée en ce que** :
la couche en silicium (300) présente une concentration en argon de 1,5 % en pourcentage atomique ou moins, et
la couche en silicium (300) présente une concentration en surface de fer, de chrome et de nickel de 5,0 E10 atomes/cm² ou moins avant ou après la liaison.

8. Procédé de fabrication pour la tranche composite (10) selon la revendication 7, dans lequel la couche en silicium (300) est en silicium amorphe.

9. Procédé de fabrication pour la tranche composite (10) selon la revendication 8, dans lequel la couche en silicium (300) est formée au moyen d'un dépôt physique en phase vapeur/PVD ou d'un dépôt chimique en phase vapeur/CVD.

10. Procédé de fabrication pour la tranche composite (10) selon l'une quelconque des revendications 7 à 9,
dans lequel l'épaisseur de la couche en silicium (300) est comprise entre 2 nm et 250 nm, bornes comprises.

11. Procédé de fabrication pour la tranche composite (10) selon l'une quelconque des revendications 7 à 10,
dans laquelle chaque substrat parmi le premier substrat (100) et le second substrat (500) est soit en silicium, soit en verre, soit en alumine, soit en saphir, soit en tantalate de lithium, soit en niobate de lithium.

12. Procédé de fabrication pour la tranche composite (10) selon la revendication 11, dans lequel au moins une couche parmi la première couche (200) et la seconde couche (400) est soit en SiO₂, soit en SiON, soit en SiN.

13. Procédé de fabrication pour la tranche composite (10) selon l'une quelconque des revendications 7 à 12,
dans lequel soit le premier substrat (100), soit le second substrat (500) subit une implantation ionique à l'avance.

14. Procédé de fabrication pour la tranche composite (10) selon l'une quelconque des revendications 7 à 13,
dans lequel une atmosphère d'activation à l'aide de plasma contient au moins un flux gazeux parmi l'azote, l'oxygène, un mélange de gaz oxygène et azote, et l'argon.

15. Procédé de fabrication pour la tranche composite (10) selon l'une quelconque des revendications 7 à 13,
dans lequel une atmosphère d'activation à l'aide de plasma contient de l'argon.
